# EUROPÄISCHE PATENTSCHRIFT

(11) **EP 1 704 758 B1**
(45) Veröffentlichungstag und Bekanntmachung des Hinweises auf die Patenterteilung: **11.04.2012**
(21) Anmeldenummer: 04803475.5
(22) Anmeldetag: 03.12.2004
(51) Int. Cl.: H05K 1/03, H05K 3/46, H05K 3/02, B29C 44/32

(54) **VERFAHREN ZUM HERSTELLEN VON LEITERPLATTEN UND LEITERPLATTE**
METHOD FOR THE PRODUCTION OF PRINTED CIRCUIT BOARDS AND PRINTED CIRCUIT BOARD
PROCEDE DE FABRICATION DE CARTES À CIRCUIT INTEGRÉ ET CARTE À CIRCUIT INTEGRÉ

(30) Priorität: 03.12.2003 DE 10356882
(43) Veröffentlichungstag der Anmeldung: 27.09.2006
(73) Patentinhaber: Würth Elektronik Rot am See GmbH & Co. KG, 74585 Rot am See (DE); Lüberg Elektronik GmbH & Co. Rothfischer KG, 92637 Weiden (DE); Reifenhäuser GmbH & Co. Maschinenfabrik, 53839 Troisdorf (DE); Lehmann & Voss & Co. KG, 20354 Hamburg (DE)
(72) Erfinder: LANGENFELDER, Dieter, 91347 Aufsess (DE); AHLSTAEDT, Volker, 21224 Rosengarten (DE)
(74) Vertreter: Patentanwälte Ruff, Wilhelm, Beier, Dauster & Partner
(86) Internationale Anmeldenummer: PCT/EP2004/013746
(87) Internationale Veröffentlichungsnummer: WO 2005/055679

(56) Entgegenhaltungen:
- DE-A1- 19 840 991
- FR-A- 2 525 849
- US-A- 2 983 962
- US-A- 4 415 392
- US-A- 4 496 415

## Beschreibung

Die Erfindung betrifft ein Verfahren zum Herstellen einer Leiterplatte sowie eine Leiterplatte selbst.

Leiterplatten für elektronische Schaltungen bestehen üblicherweise aus einem Duroplast, da man davon ausgeht, dass die Leiterplatten eine bestimmte mechanische Festigkeit haben sollen. Beim Löten entstehen hohe Temperaturen, die zumindest kurzzeitig auf die Leiterplatten einwirken. Zudem benötigen die bekannten Leiterplatten Flammschutzmittel, die eine Umweltbelastung darstellen.

Es ist bereits eine Laminatstruktur bekannt (EP 1410906), die aus einem geschäumten Kern und den Kern beidseitig umgebenden Anordnungen aus Leitern und wasserundurchlässigen Membranen besteht. Der Kern wird vorher hergestellt und als Spule aufgewickelt.

Weiterhin ist eine Leiterplatte bekannt (FR 2525849), die einen geschäumten Kern aufweist, die von zwei Deckschichten aus einem anderen Material umgeben ist. Auf die Deckschichten kann eine Metallschicht aufgebracht werden. Der Kern besteht aus einem PVC.

Zusätzlich ist es bekannt, aus einer Schmelze eines thermoplastischen Polymers durch Hinzufügen eines Treibmittels durch Extrudieren eine geschäumte Folie mit einer vergrößerten mechanischen Festigkeit herzustellen (DE 19840991 A1).

Der Erfindung liegt die Aufgabe zu Grunde, eine kostengünstige Möglichkeit zur Herstellung von Leiterplatten zu schaffen.

Zur Lösung dieser Aufgabe schlägt die Erfindung ein Verfahren mit den im Anspruch 1 und/oder mit den im Anspruch 2 genannten Merkmalen sowie eine Leiterplatte nach Anspruch 22 vor. Weiterbildungen der Erfindung sind Gegenstand von Unteransprüchen.

Die von der Erfindung vorgeschlagene Leiterplatte wird folgendermaßen hergestellt. Ein Ausgangsmaterial, nämlich ein Thermoplast, wird mittels eines Extruders plastifiziert. In erhitztem Zustand wird dieses Material begast, die gasbeladene Schmelze ggf. gekühlt und als Band extrudiert. Nach dem Extrudieren wird es gegebenenfalls auf eine zur Weiterbehandlung erforderliche Temperatur herunter gekühlt.

Auf diese Weise entsteht ein Ausgangsband, das mit geringem Materialaufwand hergestellt ist und das sich in einfacheren Fällen schon als Leiterplattenbasismaterial verwenden lässt. Unter einfacheren Fällen sind solche zu verstehen, bei denen kein Löten mehr erforderlich ist, also keine höheren Temperaturen mehr auftreten. Hier ist an Antennenanwendungen gedacht.

Die Materialersparnis entsteht durch die Schäumung, wobei durch die Verwendung eines speziellen Thermoplastes (selbstverlöschend) die Notwendigkeit von Flammschutzmitteln beseitigt werden kann.

Durch entsprechende Gestaltung und Materialauswahl ist es auch möglich, dieses Band flexibel zu gestalten, so dass eine flexible und verformbare Leiterplatte möglich ist.

Je nach Erfordernis kann erfindungsgemäß vorgesehen werden, zur Bildung einer mikrozellulären Schaumstruktur eine Dichtereduktion im Bereich von etwa 15 bis etwa 40 % durchzuführen.

Es ist aber ebenfalls möglich, eine Dichtereduktion von mehr als 40 % durchzuführen.

Um die Leiterplatte auch für beim Bestücken auftretende höhere Temperaturen geeigneter zu machen, ist erfindungsgemäß vorgesehen, als Ausgangsmaterial für das geschäumte Band ein Hochtemperaturthermoplast zu verwenden. Hierfür kommen insbesondere PI, PEI, PSU, PES, PPS, PEEK, LCP in Frage.

Die beim Herstellen des geschäumten Bandes erforderliche Schäumung kann beispielsweise physikalisch durchgeführt werden, das heißt durch Einleiten eines die Schäumung bewirkenden Gases oder einer Flüssigkeit in einen Extruder, in dem die Extrusion des Bandes durchgeführt wird.

Es ist aber ebenfalls möglich, die Schäumung chemisch durchzuführen, wobei auch Kombinationen der beiden Schäumungsmöglichkeiten im Rahmen der Erfindung liegen sollen.

Erfindungsgemäß kann vorgesehen sein, dass die Oberflächen des extrudierten Bandes geglättet werden. Diese Glättung dient dazu, eine definierte Oberflächenstruktur zu schaffen, wobei auch eine Oberflächenstrukturierung möglich ist. Die Glättung kann in Weiterbildung der Erfindung insbesondere in einem Glättwerk durchgeführt werden, wobei vorzugsweise Walzentemperaturen von 130 bis 300 °C eingestellt werden.

In Weiterbildung der Erfindung kann vorgesehen sein, das geschäumte Band auf mindestens einer Seite, vorzugsweise auf beiden Seiten, mit einer Deckschicht zu versehen, die mindestens teilweise aus thermoplastischem Material besteht. Es wird dadurch eine Sandwichstruktur geschaffen, die innen aus dem geschäumten Kern und beidseits aus den Deckschichten besteht. Die Deckschichten verleihen der Sandwichstruktur eine größere Stabilität.

Erfindungsgemäß kann die Deckschicht oder beide Deckschichten aus einem Hochtemperaturthermoplast hergestellt werden.

Eine besonders sinnvolle und einfache Herstellungsmöglichkeit besteht darin, dass die Deckschicht oder beide Deckschichten koextrudiert werden.

Erfindungsgemäß kann vorgesehen sein, dass die Deckschicht aus einem anderen Material hergestellt wird als der geschäumte Teil der Leiterplatte. Hierdurch wird es möglich, die Leiterplatte speziell an bestimmte Erfordernisse anzupassen, die an die Oberfläche der Leiterplatte gestellt werden, ohne dass es erforderlich ist, den Kern ebenfalls hieran anzupassen.

Beispielsweise kann die Deckschicht aus einem Material höherer Temperaturbeständigkeit hergestellt werden als der geschäumte Teil der Leiterplatte.

Es ist aber ebenfalls möglich und liegt im Rahmen der Erfindung, dass die Deckschicht aus dem gleichen Material hergestellt wird wie der geschäumte Teil der Leiterplatte. Trotz der Verwendung des gleichen Materials ist es auch hier möglich, die Deckschicht anders auszugestalten als den geschäumten Kern. Beispielsweise kann man die Deckschicht weniger stark schäumen als den Kern, oder aber man kann sogar die Deckschicht überhaupt nicht schäumen.

In nochmaliger Weiterbildung der Erfindung kann vorgesehen sein, die Deckschicht aus einem Blend verschiedener Hochtemperaturthermoplaste herzustellen. Beispiele für derartige Hochtemperaturthermoplaste sind eingangs genannt worden.

Bei der Herstellung der Deckschicht aus mehreren Thermoplasten kann insbesondere so vorgegangen werden, dass die Materialien der Deckschicht über dem Glasübergangspunkt aufgeheizt und anschließend auf die Verarbeitungstemperatur des Blends abgekühlt werden.

Weiterhin ist es möglich, in die Deckschicht Fasern aus einem Hochtemperaturthermoplast einzubringen. Dabei kann insbesondere vorgesehen sein, dass die Fasern nach dem Aufschmelzprozess der Deckschicht zugegeben werden, damit die Fasern selbst nicht oder nur geringfügig geschmolzen werden und als Fasern verbleiben. Es ist auch denkbar, hier Glasfasern einzubringen.

Die Zusammensetzung der Deckschicht kann so gewählt werden, dass ein recyceltes thermoplastisches Material in den Deckschichten für zugegebene Fasern aus Hochtemperaturthermoplasten als Matrix dient, so dass die Vorteile eines Einstoffsystems genutzt werden können.

Beispielsweise kann PEI die Funktion der Matrix und PEEK die der Faser übernehmen. Es ist auch denkbar, dass ein PEEK-PEI-Blend als Matrix für PEEK Fasern dient.

Bei einer Leiterplatte, die aus einem geschäumten Kern und zwei Deckschichten besteht, wird vorteilhafterweise die Glättung an der Oberfläche der Deckschichten durchgeführt.

In nochmaliger Weiterbildung der Erfindung kann in den geschäumten Teil der Leiterplatte ein Leiter mit extrudiert werden. Als Leiter kommt insbesondere Kupfer und andere metallische Leiter oder Leiterverbunde in Frage, sowie Leitpasten und alternative elektrisch leitfähige Materialien, beispielsweise elektrisch leitfähige Polymere. Erfindungsgemäß kann auf mindestens eine Deckschicht eine Leiterschicht aufgebracht werden, vorzugsweise vor der Glättung der Oberfläche in noch warmem Zustand der Deckschichten. Dabei kann die Glättung mit Hilfe der Walzen des Glättwerks gleichzeitig dazu dienen, die Leiterschicht fest mit den Deckschichten zu verbinden.

Es ist aber ebenfalls möglich und liegt im Rahmen der Erfindung, die Leiterschicht vor dem Verbinden der Deckschichten mit der Kernschicht auf die Deckschichten aufzubringen.

Vor dem Verbinden der Leiterschicht mit der Deckschicht kann die Leiterschicht beispielsweise auf 130 bis 300 °C vorgewärmt werden. Dies kann insbesondere dadurch geschehen, dass die Leiterschichten über einen mehr oder weniger großen Bereich die Glättwalzen des Glättwerks berühren, bevor sie mit den Deckschichten in Verbindung gebracht werden.

Es wurde bereits erwähnt, dass die Leiterplatte auch flexibel hergestellt werden kann. Erfindungsgemäß kann so vorgegangen werden, dass bestimmte Bereiche der Leiterplatte als Falt- oder Biegebereiche ausgestaltet werden, also beispielsweise frei von einer Kontaktierung bleiben.

Die nach der Erfindung hergestellte Leiterplatte bietet die Möglichkeit der thermischen und mechanischen Verformbarkeit vor, während und nach dem Fertigungsprozess. Diese Eigenschaft kann für verschiedene Möglichkeiten genutzt werden. Diskrete Steckverbindungen können durch Ausbildung der Biegestellen als Schnittstellen für die Kontaktierung dienen. Direkt auf der Platine können Schalter und Tastfunktionen gebildet werden. Ebenfalls direkt aus der Platine können mechanische Halterungen für elektronische und mechanische Komponenten gebildet werden. Die mechanischen Eigenschaften können durch gezielten Einsatz von Biegekanten oder durch die Integration von metallischen Platinen verstärkt werden, beispielsweise die Biegung um 180 Grad mit einem in Sandwichbauweise eingelegten Blech. Die metallischen Platinen können gleichzeitig die Funktion des Kühlblechs und der elektromagnetischen Abschirmung übernehmen. Der entscheidende Nutzen einer Nachverformung ist, dass die Leiterplatten so weit wie möglich zweidimensional verarbeitet werden können und erst nach dem Fertigungsprozess dreidimensional definiert verformt werden. Dies ergibt einen besonders kostengünstigen Produktionsprozess.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:
- Figur 1: schematisch die Übersicht über die Herstellung einer Leiterplatte;
- Figur 2: in vergrößertem Maßstab ebenfalls schematisch die Herstellung der Leiterplatte und das Aufbringen von Leiterschichten auf diese.

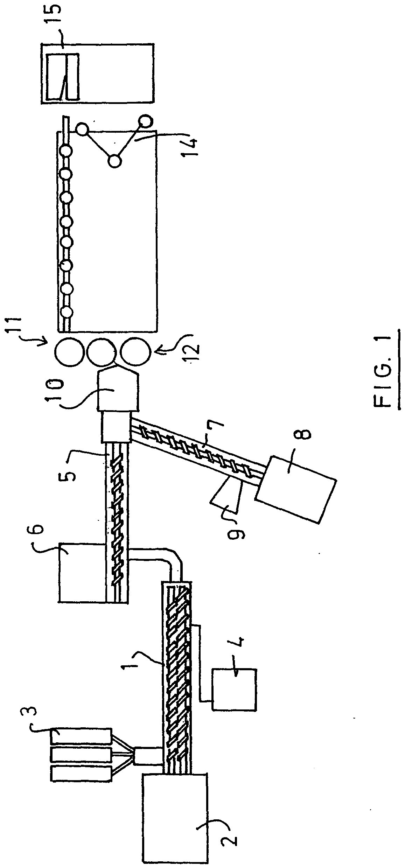

Die in Figur 1 in Übersicht dargestellte Anlage zu Herstellung von Leiterplatten in kontinuierlichen Verfahren enthält einen Doppelschneckenextruder 1, der mit Hilfe eines Antriebs 2 angetrieben wird. In dem mit zwei Schnecken versehenen Extruder 1 werden über Eingabeeinrichtungen 3 die Ausgangsmaterialien eingebracht. In dem Doppelschneckenextruder 1 erfolgt eine Erwärmung des Materials und eine Homogenisierung. In das dann erwärmte und homogenisierte thermoplastische Material wird dann im Endbereich des Extruders Gas mit Hilfe eines Kompressors 4 eingegeben. Dieses Gas führt beim Verlassen der Düse durch den Druckabfall zu einer Aufschäumung des warmen geschmolzenen Materials.

Dieses Material wird dann in einen zweiten Extruder 5 eingebracht, nämlich einen Kühlextruder. Dieser enthält ebenfalls einen Antrieb 6. Im Endbereich des Kühlextruders 5 ist ein dritter Extruder 7 angeordnet, der wiederum von einem Antrieb 8 angetrieben wird. Mit Hilfe dieses in den Kühlextruder einspeisenden Extruders 7 erfolgt die erwähnte Koextrusion der Deckschichten. Dieser dritte Extruder 7 enthält eine Eingabemöglichkeit 9 zur Eingabe von zusätzlichen Materialien, wie beispielsweise Fasern.

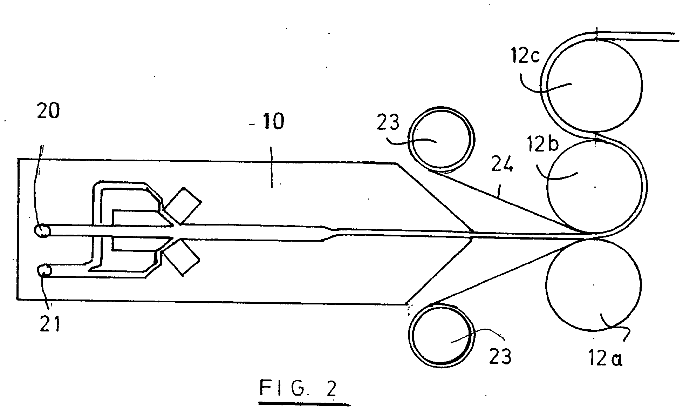

Am Ende des Kühlextruders 5 und stromab des Koextruders 7 ist eine Breitschlitzdüse 10 angeordnet, aus deren Endbereich ein flaches Band kontinuierlich austritt. Dieses gelangt in ein sich an die Austrittsdüse 10 unmittelbar anschließendes Glättwerk 11. Das Glättwerk 11 enthält drei gegenläufig rotierende Walzen 12, die dazu dienen, das extrudierte Band zu kühlen und zu glätten. Es werden temperierbare Walzen benutzt, die eine Temperatur zwischen 130 und 300 ° Celsius aufweisen können. Einzelheiten dieses Glättwerk sind in Figur 2 dargestellt, auf die später noch Bezug genommen wird.

An das Glättwerk 11 schließt sich eine Kühlstrecke an, in der das Band weiter abgekühlt und weiter transportiert wird. Je nachdem, ob das Band flexibel ist oder nicht, kann es mit einer Aufwickeleinrichtung 14 aufgewickelt werden oder einer Schlagschere 15 zugeführt werden, die das Band in einzelne Teile zerteilt.

### Nun zu Figur 2.

Figur 2 zeigt links einen schematisierten Schnitt durch einen Koextrusionsblock und eine Breitschlitzdüse 10, die in Figur 1 angedeutet ist. In einem ersten Kanal 20 kommt das geschäumte Material für die Kernschicht in die Düse. Aus einem zweiten Kanal 21, der sich dann verzweigt, gelangt das Material für die beiden Deckschichten. Die eine Hälfte dieses Materials wird an der Oberseite der Kernschicht eingeführt, die andere Hälfte an der Unterseite der Kernschicht. Natürlich ist auch eine andere Aufteilung möglich. Dadurch bildet sich eine Sandwichstruktur zur Bildung eines Bandes, das eine mit zwei Deckschichten eingefasste Kernschicht enthält. Dieses so gebildete Band verlässt dann das äußere Ende der Düse als flaches kontinuierliches Band 22.

Oberhalb und unterhalb der Ausgangsdüse ist jeweils ein Abwickler 23 mit einer aufgewickelten Kupferschicht angeordnet. Die Höheneinstellung der beiden Abwickler 23 ist veränderbar. Von jedem Abwickler 23 führt die Kupferschicht 24 zwischen die beiden unteren Walzen 12a und 12b. Die beiden Kupferschichten 24 fassen das Band 22 zwischen sich ein. In dieser Anordnung werden diese Schichten dann zwischen den beiden Walzen 12a und 12b miteinander verpresst. Die Walzen dienen gleichzeitig dem Transport, der Erwärmung der Kupferschichten 24 und der Abkühlung des wärmeren Bandes 22. Das Band 22 mit den jetzt anhaftenden Kupferschichten 24 gelangt dann von der mittleren Walze 12b zu der oberen Walze 12c, um die es um einen halben Bogen herum geführt ist. Von dort aus gelangt es in die Kühlstrecke 13.

## Patentansprüche

1. Verfahren zum Herstellen von Leiterplatten, mit folgenden Verfahrensschritten:
1.1 ein thermoplastisches Material aus Hochtemperaturthermoplast oder einem Blend verschiedener Hochtemperaturthermplaste wird mittels eines Extruders plastifiziert,
1.2 das plastifizierte Material wird mit Gas beladen,
1.3 die gasbeladene ggf. gekühlte Schmelze wird kontinuierlich als geschäumtes Band extrudiert,
1.4 zur Bildung einer mikrozellulären Schaumstruktur wird eine Dichtereduktion in dem geschäumten Band von mehr als 15 % durchgeführt,
1.5 das geschäumte Band wird auf mindestens einer Seite mit einer Deckschicht versehen, die aus dem gleichen Material wie der geschäumte Teil der Leiterplatte besteht.

2. Verfahren zum Herstellen von Leiterplatten, mit folgenden Verfahrensschritten:
2.1 ein thermoplastisches Material aus Hochtemperaturthermoplast oder einem Blend verschiedener Hochtemperaturthermplaste wird erhitzt,
2.2 in das erhitzte Material wird ein chemisches oder physikalisches Treibmittel eingebracht und dispergiert,
2.3 das Material wird als Band kontinuierlich extrudiert, wobei es beim Verlassen der Düse aufschäumt,
2.4 zur Bildung einer mikrozellulären Schaumstruktur wird eine Dichtereduktion in dem geschäumten Band von mehr als 15 % durchgeführt,
2.5 das geschäumte Band wird auf mindestens einer Seite mit einer Deckschicht versehen wird, die aus dem gleichen Material wie der geschäumte Teil der Leiterplatte besteht.

3. Verfahren nach Anspruch 1 oder 2, bei dem eine Dichtereduktion von mehr als 40 % durchgeführt wird.

4. Verfahren nach einem der vorhergehenden Ansprüche, bei dem mindestens teilweise eine physikalische Schäumung durchgeführt wird.

5. Verfahren nach einem der vorhergehenden Ansprüche, bei dem mindestens teilweise eine chemische Schäumung durchgeführt wird.

6. Verfahren nach einem der vorhergehenden Ansprüche, bei dem die Oberflächen des extrudierten Bandes (22) geglättet werden.

7. Verfahren nach Anspruch 6, bei dem die Oberflächen des extrudierten Bandes (22) in einem Glättwerk (12) mit Walzentemperaturen von 130 ° bis 300° Celsius geglättet werden.

8. Verfahren nach einem der vorhergehenden Ansprüche, bei dem die Deckschicht koextrudiert wird.

9. Verfahren nach einem der vorhergehenden Ansprüche, bei dem die Deckschicht weniger stark als der geschäumte Kern der Leiterplatte oder gar nicht geschäumt wird.

10. Verfahren nach einem der vorhergehenden Ansprüche, bei dem in die Deckschicht Fasern aus Hochtemperaturthermoplast zugegeben werden.

11. Verfahren nach Anspruch 10, bei dem die Fasern nach dem Aufschmelzprozess der Deckschicht zugegeben werden.

12. Verfahren nach Anspruch 10 oder 11, bei dem in die Deckschicht recyceltes thermoplastisches Material als Matrix für zugegebene Fasern aus Hochtemperaturthermoplast dient.

13. Verfahren nach einem der Ansprüche 6 bis 12, bei dem die Glättung an der Oberfläche der Deckschichten erfolgt.

14. Verfahren nach einem der vorhergehenden Ansprüche, bei dem in den geschäumten Teil der Leiterplatte ein Leiter mit extrudiert wird.

15. Verfahren nach Anspruch 14, bei dem als Leiter Kupfer, , Leiterverbunde, Leitpasten sowie wärmeleitfähige Materialien verwendet werden.

16. Verfahren nach einem der vorhergehenden Ansprüche, bei dem auf mindestens eine Deckschicht eine Leiterschicht aufgebracht wird, vorzugsweise vor der Glättung der Oberflächen in noch warmem Zustand der Deckschichten.

17. Verfahren nach Anspruch 16, bei dem die Leiterschicht vor dem Verbinden mit der Deckschicht auf eine Temperatur von etwa 130° bis 300° Celsius vorerwärmt wird.

18. Verfahren nach Anspruch 17, bei dem die Vorwärmung durch teilweise Berührung der Glättwalzen (12) des Glättwerks erfolgt.

19. Verfahren nach einem der vorhergehenden Ansprüche, bei dem die Leiterplatte flexibel hergestellt wird, z.B. als Folie.

20. Verfahren nach einem der vorhergehenden Ansprüche, bei dem das aus dem Düsenaustrittsspalt austretende Band in einen Käfig zur Kalibrierung der aufschäumenden Schmelze und zur Verhinderung einer Gardinenbildung extrudiert wird.

21. Verfahren nach einem der vorhergehenden Ansprüche, bei dem bestimmte Bereiche der Leiterplatte als Falt- oder Biegebereiche hergestellt werden.

22. Leiterplatte, enthaltend einen von zwei Deckschichten umgebenen geschäumten Kern aus einem thermoplastischen Material, dadurch gekennzechnet, dass die Deckschichten ebenso wie der geschäumte Kern aus einem Hochtemperaturthermoplast bestehen und der Kern zur Bildung einer mikrozellulären Schaumstruktur eine Dichtereduktion von zwischen 15% und 40% gegenüber dem ungeschäumten Hochtemperaturthermoplast aufweist.

23. Leiterplatte nach Anspruch 22, bei der die Deckschichten weniger stark geschäumt sind als der Kern der Leiterplatte.

24. Leiterplatte nach Anspruch 22 oder 23, bei der die Deckschichten aus einem Blend verschiedener Hochtemperaturthermoplaste bestehen.

25. Leiterplatte nach einem der Ansprüche 22 bis 24, bei der die Deckschichten Fasern eines Hochtemperaturthermoplasten enthalten, der selbst oder als Blend mit einem anderen Thermoplast als Polymermatrix dient.

26. Leiterplatte nach einem der Ansprüche 22 bis 25, bei der die Leiterplatte als Band (22) extrudiert ist und die Oberflächen des extrudierten Bandes (22) geglättet sind.

27. Leiterplatte nach Anspruch 26, bei der die Oberflächen des extrudierten Bandes (22) in einem Glättwerk (12) mit Walzentemperaturen von 130° bis 300° Celsius geglättet sind.

28. Leiterplatte nach einem der Ansprüche 22 bis 27, bei der der Kern chemisch oder physikalisch geschäumt ist.

29. Leiterplatte nach einem der Ansprüche 22 bis 28, bei der der geschäumte Kern der Leiterplatte einen mit extrudierten Leiter aufweist.

30. Leiterplatte nach Anspruch 29, bei der der Leiter Kupfer , Leiterverbunde, Leitpasten sowie wärmeleitfähige Materialien aufweist.

31. Leiterplatte nach einem der Ansprüche 22 bis 30, bei der auf mindestens einer Deckschicht eine Leiterschicht aufgebracht ist.

32. Leiterplatte nach einem der Ansprüche 22 bis 31, als flexible Leiterplatte hergestellt, z.B. als Folie.

33. Leiterplatte nach einem der Ansprüche 22 bis 32, mit Falt- oder Biegebereichen.

## Claims

1. Method for producing printed circuit boards, having the following method steps:
1.1 a thermoplastic material made from high-temperature thermoplastic or a blend of different high-temperature thermoplastics is plasticized by means of an extruder,
1.2 the plasticized material is loaded with gas,
1.3 the gas-loaded, optionally cooled melt is extruded continuously as a foamed strip,
1.4 a density reduction of more than 15% is carried out in the foamed strip in order to form a microcellular foam structure,
1.5 the foamed strip is provided on at least one side with a cover layer which consists of the same material as the foamed part of the printed circuit board.

2. Method for producing printed circuit boards, having the following method steps:
2.1 a thermoplastic material made from high-temperature thermoplastic or a blend of various high-temperature thermoplastics is heated,
2.2 a chemical or physical foaming agent is introduced and dispersed into the heated material,
2.3 the material is extruded continuously as a strip, wherein it foams when leaving the nozzle,
2.4 a density reduction of more than 15% is carried out in the foamed strip in order to form a microcellular foam structure,
2.5 the foamed strip is provided on at least one side with a cover layer which consists of the same material as the foamed part of the printed circuit board.

3. Method according to Claim 1 or 2, wherein a density reduction of more than 40% is carried out.

4. Method according to one of the preceding claims, wherein a physical foaming is carried out at least in part.

5. Method according to one of the preceding claims, wherein a chemical foaming is carried out at least in part.

6. Method according to one of the preceding claims, wherein the surfaces of the extruded strip (22) are polished.

7. Method according to Claim 6, wherein the surfaces of the extruded strip (22) are polished in a polishing stack (12) with roller temperatures from 130° to 300° Celsius.

8. Method according to one of the preceding claims, wherein the cover layer is co-extruded.

9. Method according to one of the preceding claims, wherein the cover layer is foamed less strongly than the foamed core of the printed circuit board, or not at all.

10. Method according to one of the preceding claims, wherein fibres made from high-temperature thermoplastic are added into the cover layer.

11. Method according to Claim 10, wherein the fibres are added after the melting process of the cover layer.

12. Method according to Claim 10 or 11, wherein thermoplastic material recycled into the cover layer serves as matrix for added fibres made from high-temperature thermoplastic.

13. Method according to one of Claims 6 to 12, wherein the polishing is performed on the surface of the cover layers.

14. Method according to one of the preceding claims, wherein a conductor is also extruded into the foamed part of the printed circuit board.

15. Method according to Claim 14, wherein copper, composite conductors, conductive pastes and thermally conductive materials are used as conductor.

16. Method according to one of the preceding claims, wherein a conductor layer is applied to at least one cover layer, preferably before the polishing of the surfaces when the cover layers are still in a warm state.

17. Method according to Claim 16, wherein the conductor layer is preheated up to a temperature of approximately 130° to 300° Celsius before being connected to the cover layer.

18. Method according to Claim 17, wherein the preheating is performed by partial contact with the polishing rollers (12) of the polishing stack.

19. Method according to one of the preceding claims, wherein the printed circuit board is produced to be flexible, for example as a film.

20. Method according to one of the preceding claims, wherein the strip emerging from the nozzle exit gap is extruded into a cage for calibrating the foaming melt and for preventing curtaining.

21. Method according to one of the preceding claims, wherein specific regions of the printed circuit board are produced as folding or bend regions.

22. Printed circuit board containing a foamed core surrounded by two cover layers and made from thermoplastic material, **characterized in that**, just like the foamed core, the cover layers consist of a high-temperature thermoplastic, and the core has a density reduction of between 15% and 40% compared to the unfoamed high-temperature thermoplastic for the purpose of forming a microcellular foam structure.

23. Printed circuit board according to Claim 22, wherein the cover layers are less strongly foamed than the core of the printed circuit board.

24. Printed circuit board according to Claim 22 or 23, wherein the cover layers consist of a blend of various high-temperature thermoplastics.

25. Printed circuit board according to one of Claims 22 to 24, wherein the cover layers contain fibres of a high-temperature thermoplastic which serves as polymer matrix itself or as a blend with another thermoplastic.

26. Printed circuit board according to one of Claims 22 to 25, wherein the printed circuit board is extruded as a strip (22), and the surfaces of the extruded strip (22) are polished.

27. Printed circuit board according to Claim 26, wherein the surfaces of the extruded strip (22) are polished in a polishing stack (12) with roller temperatures from 130° to 300° Celsius.

28. Printed circuit board according to one of Claims 22 to 27, wherein the core is chemically or physically foamed.

29. Printed circuit board according to one of Claims 22 to 28, wherein the foamed core of the printed circuit board has a co-extruded conductor.

30. Printed circuit board according to Claim 29, wherein the conductor has copper, composite conductors, conductive pastes and thermally conductive materials.

31. Printed circuit board according to one of Claims 22 to 30, wherein a conductor layer is applied to at least one cover layer.

32. Printed circuit board according to one of Claims 22 to 31, produced as a flexible printed circuit board, for example as a film.

33. Printed circuit board according to one of Claims 22 to 32, having folding or bend regions.

## Revendications

1. Procédé pour la fabrication de cartes de circuits imprimés, comprenant les étapes suivantes :
1.1 un matériau thermoplastique constitué de matière thermoplastique à haute température ou d'un mélange de différentes matières thermoplastiques à haute température est plastifié au moyen d'une extrudeuse,
1.2 le matériau plastifié est chargé de gaz,
1.3 la masse fondue chargée de gaz ou refroidie est extrudée en continu en une bande expansée,
1.4 pour former une structure de mousse microcellulaire, une réduction de densité de plus de 15 % est effectuée dans la bande expansée,
1.5 la bande expansée est munie d'au moins un côté d'une couche de revêtement qui est constituée du même matériau que la partie expansée de la carte de circuit imprimé.

2. Procédé pour la fabrication de cartes de circuits imprimés, comprenant les étapes suivantes :
2.1 un matériau thermoplastique constitué de matière thermoplastique à haute température ou d'un mélange de différentes matières thermoplastiques à haute température est chauffé,
2.2 un agent d'expansion chimique ou physique est introduit et dispersé dans le matériau chauffé,
2.3 le matériau est extrudé en continu en une bande et subit une expansion à la sortie de la buse,
2.4 pour former une structure de mousse microcellulaire, une réduction de densité de plus de 15 % est effectuée dans la bande expansée,
2.5 la bande expansée est munie d'au moins un côté d'une couche de revêtement qui est constituée du même matériau que la partie expansée de la carte de circuit.

3. Procédé selon la revendication 1 ou 2, dans lequel une réduction de densité de plus de 40 % est effectuée.

4. Procédé selon l'une quelconque des revendications précédentes, dans lequel une expansion physique est au moins partiellement effectuée.

5. Procédé selon l'une quelconque des revendications précédentes, dans lequel une expansion chimique est au moins partiellement effectuée.

6. Procédé selon l'une quelconque des revendications précédentes, dans lequel les surfaces de la bande extrudée (22) sont lissées.

7. Procédé selon la revendication 6, dans lequel les surfaces de la bande extrudée (22) sont lissées dans une lisseuse (12) à des températures des cylindres de 130 à 300°C.

8. Procédé selon l'une quelconque des revendications précédentes, dans lequel le couche de revêtement est coextrudée.

9. Procédé selon l'une quelconque des revendications précédentes, dans lequel la couche de revêtement est moins fortement expansée que le noyau expansé de la carte de circuit ou n'est pas expansée.

10. Procédé selon l'une quelconque des revendications précédentes, dans lequel des fibres de matière thermoplastique à haute température sont ajoutées à la couche de revêtement.

11. Procédé selon la revendication 10, dans lequel les fibres sont ajoutées après le processus de fusion de la couche de revêtement.

12. Procédé selon la revendication 10 ou 11, dans lequel un matériau thermoplastique recyclé sert de matrice dans la couche de revêtement pour les fibres de matière thermoplastique à haute température ajoutées.

13. Procédé selon l'une quelconque des revendications 6 à 12, dans lequel le lissage s'effectue à la surface des couches de revêtement.

14. Procédé selon l'une quelconque des revendications précédentes, dans lequel un conducteur est coextrudé dans la partie expansée de la carte de circuit imprimé.

15. Procédé selon la revendication 14, dans lequel du cuivre, des composites conducteurs, des pâtes conductrices ainsi que des matériaux thermiquement conducteurs sont utilisés en tant que conducteur.

16. Procédé selon l'une quelconque des revendications précédentes, dans lequel on applique une couche conductrice sur au moins une couche de revêtement, de préférence avant le lissage des surfaces des couches de revêtement encore chaudes.

17. Procédé selon la revendication 16, dans lequel la couche conductrice est préchauffée avant la liaison à la couche de revêtement à une température d'environ 130 à 300°C.

18. Procédé selon la revendication 17, dans lequel le préchauffage s'effectue par contact partiel des cylindres de lissage (12) de la lisseuse.

19. Procédé selon l'une quelconque des revendications précédentes, dans lequel la carte de circuit imprimé est réalisée de manière à être flexible, par exemple sous la forme d'une feuille.

20. Procédé selon l'une quelconque des revendications précédentes, dans lequel la bande sortant de la fente de sortie de buse est extrudée dans une cage pour l'étalonnage de la masse fondue en expansion et pour éviter un affaissement.

21. Procédé selon l'une quelconque des revendications précédentes, dans lequel certaines zones de la carte de circuit imprimé sont réalisées sous la forme de zones de pliage ou de flexion.

22. Carte de circuit imprimé comprenant un noyau expansé entouré de deux couches de revêtement constituées d'un matériau thermoplastique, **caractérisée en ce que** les couches de revêtement sont constituées, comme le noyau expansé, d'une matière thermoplastique à haute température et **en ce que**, pour former une structure de mousse microcellulaire, le noyau présente une réduction de densité comprise entre 15 % et 40 % par rapport à la matière thermoplastique à haute température non expansée.

23. Carte de circuit imprimé selon la revendication 22, dans laquelle les couches de revêtement sont moins fortement expansées que le noyau de la carte de circuit imprimé.

24. Carte de circuit imprimé selon la revendication 22 ou 23, dans laquelle les couches de revêtement sont constituées d'un mélange de différents matériaux thermoplastiques à haute température.

25. Carte de circuit imprimé selon l'une quelconque des revendications 22 à 24, dans laquelle les couches de revêtement contiennent des fibres d'une matière thermoplastique à haute température, qui est utilisée seule ou en mélange avec une autre matière thermoplastique en tant que matrice polymère.

26. Carte de circuit imprimé selon l'une quelconque des revendications 22 à 25, dans laquelle la carte de circuit imprimé est extrudée en une bande (22) et les surfaces de la bande extrudée (22) sont lissées.

27. Carte de circuit imprimé selon la revendication 26, dans laquelle les surfaces de la bande extrudée (22) sont lissées dans une lisseuse (12) à des températures des cylindres de 130 à 300°C.

28. Carte de circuit imprimé selon l'une quelconque des revendications 22 à 27, dans laquelle le noyau est expansé chimiquement ou physiquement.

29. Carte de circuit imprimé selon l'une quelconque des revendications 22 à 28, dans laquelle ledit noyau expansé de la carte de circuit imprimé comporte un conducteur coextrudé.

30. Carte de circuit imprimé selon la revendication 29, dans laquelle le conducteur comprend du cuivre, des composites conducteurs, des pâtes conductrices ainsi que des matériaux thermiquement conducteurs.

31. Carte de circuit imprimé selon l'une quelconque des revendications 22 à 30, dans laquelle on applique une couche conductrice sur au moins une couche de revêtement.

32. Carte de circuit imprimé selon l'une quelconque des revendications 22 à 31, réalisée de manière à être flexible, par exemple sous la forme d'une feuille.

33. Carte de circuit imprimé selon l'une quelconque des revendications 22 à 32, comprenant des zones de pliage ou de flexion.
